# EUROPÄISCHE PATENTSCHRIFT

(11) **EP 3 878 249 B1**
(45) Veröffentlichungstag und Bekanntmachung des Hinweises auf die Patenterteilung: **04.12.2024**
(21) Anmeldenummer: 19797668.1
(22) Anmeldetag: 30.10.2019
(51) Int. Cl.: H05K 3/40, H05K 3/24, H05K 3/00, B42D 25/305, H05K 3/42, H05K 1/11, H05K 3/12, H05K 1/02, G06K 19/077

(54) **DURCHKONTAKTIERUNG EINER BEIDSEITIG BEDRUCKTEN TRÄGERFOLIE MIT FÜLLDRUCK SOWIE EIN VERFAHREN ZUR HERSTELLUNG EINER DERARTIGEN DURCHKONTAKTIERUNG**
THROUGH-CONTACT FILLED BY PRINTING IN A TWO-SIDED PRINTED SUBSTRATE AND METHOD FOR MANUFACTURING THE SAME
CONTACT TRAVERSANT REMPLI PAR IMPRESSION DANS UN SUBSTRAT BIFACE ET SON PROCÉDÉ DE FABRICATION

(30) Priorität: 06.11.2018 DE 102018127630
(43) Veröffentlichungstag der Anmeldung: 15.09.2021
(73) Patentinhaber: Bundesdruckerei GmbH, 10969 Berlin (DE)
(72) Erfinder: BAUDACH, Steffen, 13189 Berlin (DE); FERBER, Alexander, 12105 Berlin (DE)
(74) Vertreter: Hentrich Patent- & Rechtsanwaltspartnerschaft mbB
(86) Internationale Anmeldenummer: PCT/EP2019/079751
(87) Internationale Veröffentlichungsnummer: WO 2020/094493

(56) Entgegenhaltungen:
- EP-A1- 0 595 752
- EP-A1- 0 971 570
- EP-A2- 1 096 842
- EP-A2- 1 545 175
- WO-A1-2005/117096
- WO-A1-2014/095232
- WO-A2-2013/139470
- DE-A1- 102015 005 690
- US-A- 5 203 078
- US-A- 5 227 013
- US-A1- 2011 180 310

## Beschreibung

### Gegenstand der Erfindung

Die vorliegende Erfindung betrifft ein Verfahren zum Erzeugen einer Durchkontaktierung in einer beidseitig bedruckten Trägerfolie sowie eine beidseitig bedruckte Trägerfolie mit Durchkontaktierung.

### Hintergrund der Erfindung

Mit Leiterbahnen bedruckte Trägerfolien sind im Stand der Technik beispielsweise aus WO2014/095232 bekannt. So umfassen bspw. RFID-Etiketten ("radio frequency identification"-Etiketten bzw. Etiketten zur Identifizierung mit Hilfe elektromagnetischer Wellen) eine Antenne in Form einer auf einer Folie gedruckten Leiterbahn, die mit einem RFID-Chip verbunden ist und sowohl der Energieversorgung als auch der Kommunikation mit einem RFID-Lesegerät dient.

Die Leiterbahn ist häufig spiralförmig ausgestaltet und ist an zwei voneinander entfernten Antennenabgriffen mit entsprechenden Kontakten des RFID-Chips verbunden.

Bei ausreichend großen RFID-Chips ist es möglich, die beiden Antennenabgriffe direkt mit dem RFID-Chip zu verbinden, indem der RFID-Chip unmittelbar auf die spiralförmige Leiterbahn aufgesetzt wird, wodurch zwei voneinander entfernt angeordnete Kontakte des RFID-Chips mit den Antennenabgriffen verbunden werden. Der RFID-Chip fungiert dabei als Brücke zwischen den beiden Antennenabgriffen über die zwischen den Antennenabgriffen gelegenen weiteren Wicklungen der Antenne.

In der DE 10 2015 005 690 A1 wird eine Durchkontaktierung beschrieben, bei der eine erste leitende Schicht mit einer zweiten leitenden Schicht über eine Durchkontaktierung kontaktiert wird, wobei der Durchkontaktierung zusätzlich eine Plattierung zugeordnet sein kann.

Die EP 1 096 842 A2 beschreibt ein Verfahren zur Herstellung einer mehrlagigen Leiterplatte, bei welchem ein Verfüllschritt durch Einbringen einer Tinte zur Herstellung der Durchkontaktierung durchgeführt wird.

Die US 2011 / 0 180 310 A1 beschreibt einen Aufbau für eine Leiterplatte, in den eine elektrisch leitfähige Platte zwischen zwei Durchkontaktierungen eingebettet ist.

In der EP 0 595 752 A1 wird die Herstellung einer Durchkontaktierung beschrieben, bei der zwei oder mehr elektrisch isolierende Schichten mit einem elektrisch leitfähigen Material durchdrungen werden

Die WO 2013 / 139 470 A2 beschreibt ein Substrat für einen portablen Datenträger, insbesondere eine Chipkarte, das einen ersten Antennenteil auf seiner einen Seite und einen zweiten Antennenteil auf seiner anderen Seite besitzt, wobei die beiden Antennenteile über die Durchkontaktierungsbereiche elektrisch miteinander verbindbar sind.

Die US 5,203,078 A beschreibt eine Identitätskarte, die mit einem integrierten Schaltkreis (IC) versehen ist, wobei auch hier eine Durchkontaktierung vorliegt.

Die WO 2005 / 117 096 A1 beschreibt ein Chipmodul, das über eine elektrische Durchkontaktierung mit einer Antenne an einem Substrat fixiert ist. Hierbei wird zunächst eine Durchgangsbohrung in dem Substrat erzeugt und mit einem ersten Füllmaterial verfüllt, wobei anschließend die Antenne mittels elektrochemischer Abscheidung auf das Substrat aufgebracht wird.

### Beschreibung der Erfindung

Vor dem beschriebenen Hintergrund ist es Aufgabe der vorliegenden Erfindung, ein verbessertes Verfahren zur Herstellung einer beidseitig bedruckten Trägerfolie zur Verfügung zu stellen, wobei insbesondere die Leitfähigkeit im Bereich der Durchkontaktierung weiter verbessert wird.

Diese Aufgabe wird durch Verfahren zum Erzeugen einer Durchkontaktierung in einer beidseitig mit Leiterbahnen bedruckten Trägerfolie nach Anspruch 1, eine Trägerfolie nach Anspruch 7, ein RFID-Inlay nach Anspruch 10 und ein Wert- oder Sicherheitsdokument nach Anspruch 11 gelöst. Die abhängigen Ansprüche enthalten weitere, vorteilhafte Ausgestaltungen der Erfindung.

Die Erfindung beruht auf der Erkenntnis und schließt diese mit ein, dass aufgrund der fortschreitenden Miniaturisierung der RFID-Chips eine Überbrückung der Antennenwicklungen zunehmend schwierig wird, da der Abstand der Kontakte der RFID-Chips häufig geringer ist als der minimale mit vertretbarem Aufwand herstellbare Abstand der beiden Antennenabgriffe der Leiterbahn.

Das erfindungsgemäße Verfahren zum Erzeugen einer Durchkontaktierung in einer beidseitig mit Leiterbahnen bedruckten Trägerfolie, wobei die Trägerfolie eine erste Seite und eine zweite Seite umfasst, umfasst mehrere Schritte.

Die erste Seite der Trägerfolie wird mit elektrisch leitendem Material bedruckt, wobei der Bereich der vorgesehenen Durchkontaktierung überdeckt wird. Danach wird ein Durchgangsloch in die Trägerfolie eingebracht. Die zweite Seite der Trägerfolie wird mit elektrisch leitendem Material bedruckt, vorzugsweise teilweise bedruckt. Dabei wird das Durchgangsloch mit elektrisch leitendem Material verfüllt, bevorzugt vollständig überdeckt. Die zweite Seite der Trägerfolie wird mindestens ein weiteres Mal mit elektrisch leitendem Material bedruckt. Dabei wird das Durchgangsloch und das bereits aufgedruckte elektrisch leitende Material verfüllt, bevorzugt vollständig überdeckt.

Verfüllen ist im Zusammenhang mit der vorliegenden Erfindung so zu verstehen, dass über den gesamten Bereich bzw. die gesamte Querschnittsfläche des Durchgangsloches ein Materialschluss zwischen dem auf der ersten Seite und der zweiten Seite aufgedruckten elektrisch leitendem Material hergestellt wird. Ein vollständiges Auffüllen bzw. Ausfüllen des Durchgangslochs oder des in diesem Zusammenhang abgetragenen Volumens mit elektrisch leitendem Material bis zur Oberfläche der zweiten Seite ist von Vorteil, aber nicht zwingend erforderlich.

Die erste Seite der Trägerfolie wird bevorzugt teilweise, nämlich im Bereich der vorgesehenen Durchkontaktierung, mit elektrisch leitendem Material bedruckt. Vorzugsweise wird der Bereich der vorgesehenen Durchkontaktierung vollständig mit elektrisch leitendem Material überdeckt.

Das erfindungsgemäße Verfahren hat den Vorteil, dass durch einen zusätzlichen Druckschritt ein Fülldruck vorgenommen wird, der dazu führt, dass mehr leitfähiges Material in der Durchkontaktierung vorhanden ist. Gleichzeitig wird eine erhöhte Stabilität gegenüber lateralen Einschnürungen in einer anschließenden Lamination erzielt. Weiterhin wird die Leitfähigkeit erhöht bzw. der elektrische Widerstand verringert. "Abrisse" des Fülldrucks an den Flanken des Durchgangsloches werden durch den weiteren Druck, der zugleich ein Antennendruck ist, ausgeglichen. Damit ergeben sich höhere Ausbeuten und eine höhere Toleranz gegenüber ungünstigen Geometrien des Durchgangsloches. Löcher mit einem größeren Aspektverhältnis können verfüllt werden, zum Beispiel bei einer Verwendung dickerer Substrate, wenn aufgrund der Empfindlichkeit der freigelegten "Membran" der Lochdurchmesser nicht vergrößert werden kann.

Das Bedrucken der ersten Seite der Trägerfolie mit elektrisch leitendem Material erfolgt vor dem Einbringen des Durchgangsloches in die Trägerfolie.

Erfindungsgemäß erfolgt das Einbringen des Durchgangslochs nach dem Bedrucken der ersten Seite, wobei das bereits aufgebrachte elektrisch leitende Material erhalten bleibt. Das Material aus dem ersten Druckschritt bildet also einen elektrisch leitenden Abschluss des Durchgangslochs, der eine gute elektrische Verbindung mit dem im zweiten Druckschritt in das Durchgangsloch eingebrachten elektrisch leitenden Material gewährleistet. Durch die genannten Varianten lässt sich das Verfahren flexibel in bereits bestehende Prozesse integrieren.

Zum Beispiel können zunächst in einem ersten Druckschritt Leiterbahnen auf der ersten Seite der Trägerfolie aufgebracht werden, bevor nach Abschluss des ersten Druckschritts in einem zweiten und dritten Druckschritt der Fülldruck und Leiterbahnen, erfindungsgemäß als Antennendruck, auf die zweite Seite der Trägerfolie aufgebracht werden. Es ist aber auch möglich, dass mehrere Druckschritte gleichzeitig oder sich zeitlich überlappend ausgeführt werden. Erfolgt das Einbringen des Durchgangslochs vor dem ersten Druckschritt oder erstreckt sich das Durchgangsloch bei Einbringen nach dem ersten Druckschritt auch durch das bereits aufgebrachte elektrisch leitendende Material, was nicht in den Schutzbereich der Ansprüche fällt, ist bevorzugt, wenn das Durchgangsloch derart dimensioniert ist, dass das in den darauffolgenden Druckschritten, insbesondere dem ersten und zweiten Druckschritt, aufgebrachte elektrisch leitende Material nicht durch das Durchgangsloch durchschießt. In anderen Worten soll das auf einer Seite der Trägerfolie aufgedruckte elektrisch leitende Material im Wesentlichen nicht durch das Durchgangsloch hindurch und frei auf der anderen Seite hinaustreten; vielmehr soll es in dem Durchgangsloch verbleiben, um dieses auszufüllen. Dies kann regelmäßig durch einen ausreichend kleinen, an die Fließeigenschaften des elektrisch leitenden Materials während des Druckvorgangs angepassten Querschnitt des Durchgangslochs insgesamt oder zumindest an der anderen Seite erreicht werden. Beispielsweise kann das Durchgangsloch kegelstumpfförmig mit einem zu der anderen Seite hin abnehmenden Querschnitt geformt werden.

Das Bedrucken, insbesondere das erste Bedrucken der zweiten Seite, kann mittels Siebdruck oder mittels eines Jet-Druckverfahrens erfolgen. Es sind aber auch andere Technologien denkbar, die zur Erhöhung der eingebrachten leitfähigen Materialmenge geeignet sind.

Der Durchmesser des Durchgangslochs kann 50 Mikrometer bis 5000 Mikrometer betragen. Insbesondere, wenn das Durchgangsloch nach dem ersten Druckschritt unter Erhaltung des dabei aufgebrachten elektrisch leitenden Materials eingebracht wird, ist bevorzugt, wenn der Durchmesser des Durchgangslochs 100 Mikrometer bis 500 Mikrometer beträgt. Durch einen entsprechenden Durchmesser ist eine sichere Durchkontaktierung mit hohem elektrischem Leitwert gewährleistet. Die Gefahr eines Durchschießens des im zweiten Druckschritt aufgebrachten Materials besteht in diesem Fall nicht. Insbesondere in den Fällen, in dem ein Durchschießen grundsätzlich möglich ist, beträgt der Durchmesser des Durchgangslochs vorzugsweise 50 Mikrometer bis 200 Mikrometer. Bei üblichen, für Druckverfahren verwendeten elektrisch leitenden Materialien kann dadurch ein Durchschießen des Materials vermieden werden. Die Dicke der Trägerfolie beträgt vorzugsweise 20 Mikrometer bis 250 Mikrometer, weiter vorzugsweise 50 Mikrometer bis 100 Mikrometer, sodass ein möglichst weitgehendes bis vollständiges Füllen des Durchgangslochs durch in einem Druckschritt aufgebrachtes elektrisch leitendes Material sichergestellt ist. Die Dicke der Trägerfolie und der Durchmesser des Durchgangslochs werden üblicherweise in Abhängigkeit voneinander gewählt, wobei eine dickere Trägerfolie mit einem größeren Durchmesser des Durchgangslochs einhergeht.

Auch wenn vorstehend Maße für den Durchmesser des Durchgangsloches angegeben sind, ist die Formgebung des Durchgangsloches nicht auf die bevorzugte kreisrunde Ausgestaltung beschränkt. Im Falle eines nicht kreisrunden Durchgangslochs ist auf die mit den Durchmesserangaben unmittelbar verknüpfte Querschnittsfläche des Durchgangsloches abzustellen, also vorzugsweise 0,002 Quadratmillimeter bis 20,0 Quadratmillimeter, weiter vorzugsweise 0,008 Quadratmillimeter bis 0,2 Quadratmillimeter oder 0,002 Quadratmillimeter bis 0,03 Quadratmillimeter.

Das Einbringen des Durchgangslochs kann beispielsweise durch Stanzen, Bohren oder Lasern, vorzugsweise CO2-Lasern, erfolgen. Insbesondere wenn beim Einbringen im ersten Druckschritt bzw. beim Bedrucken der ersten Seite aufgebrachtes elektrisch leitendes Material möglichst weitgehend erhalten bleiben soll, ist das Durchgangsloch bevorzugt durch Lasern einzubringen, da so die dabei erforderliche Genauigkeit ohne weiteres eingehalten werden kann.

Es ist bevorzugt, wenn das elektrisch leitende Material Silberleitpaste umfasst oder aus Silberleitpaste besteht. Silberleitpaste eignet sich gut für den Druck von Leiterbahnen. Die Trägerfolie umfasst bevorzugt Polycarbonat oder besteht aus Polycarbonat. Eine Trägerfolie aus Polycarbonat kann mit weiteren Lagen aus Polycarbonat durch Laminieren zu einem als Schichtverbund aufgebauten RFID-Sicherheitsdokument verbunden werden, ohne dass sich eine erhöhte Gefahr von Delaminationen aufgrund inkompatibler Materialien der Schichten des Schichtverbundes ergäbe.

Die erfindungsgemäße, beidseitig mit Leiterbahnen bedruckte Trägerfolie weist wenigstens eine erfindungsgemäß hergestellte Durchkontaktierung auf. Zur weiteren Erläuterung wird auf die vorstehenden Ausführungen verwiesen. Da der elektrische Leitwert einer Durchkontaktierung aufgrund der für das erfindungsgemäße Verfahren erforderlichen Dimensionierung des Durchgangsloches für eine vorgesehene Verwendung gegebenenfalls zu gering ist, ist es möglich, jeweils eine Leiterbahn auf unterschiedlichen Seiten der Trägerfolie durch ein Feld von wenigstens zwei Durchkontaktierungen elektrisch miteinander zu verbinden. Die vorzugsweise eng benachbart zueinander angeordneten Durchkontaktierungen stellen so parallele Verbindungen zwischen den beiden Leiterbahnen her, wodurch sich ein erhöhter kumulierter elektrischer Leitwert zwischen den beiden Leiterbahnen ergibt. Zudem ergibt sich eine Redundanz der Durchkontaktierungen, wodurch eine ungenügende Kontaktierung in einer Durchkontaktierung durch eine gelungene Kontaktierung in einer anderen Durchkontaktierung aufgefangen wird.

Es ist weiter bevorzugt, wenn zwei durch wenigstens eine Durchkontaktierung verbundene Leiterbahnen auf der Trägerfolie Kontaktstellen zur Überprüfung der Durchkontaktierung(en) umfassen. An den Kontaktstellen können Prüfspitzen eines Messgerätes angelegt werden und so das grundsätzliche Bestehen einer elektrischen Verbindung über die Durchkontaktierung(en) und/oder der elektrische Widerstand bzw. der elektrische Leitwert der Durchkontaktierung(en) überprüft werden.

Das erfindungsgemäße RFID-Inlay umfasst eine erfindungsgemäße Trägerfolie und einem mit den Leiterbahnen verbundenen RFID-Chip. Das erfindungsgemäße Wert- oder Sicherheitsdokument umfasst ein solches erfindungsgemäßes RFID-Inlay. Das erfindungsgemäße RFID-Inlay und erfindungsgemäße Wert- oder Sicherheitsdokument haben die oben bereits im Zusammenhang mit dem erfindungsgemäßen Verfahren und der erfindungsgemäßen Trägerfolie genannten Merkmale und Vorteile. Typische Beispiele für ein Wert- oder Sicherheitsdokument gemäß der vorliegenden Erfindung sind Personalausweise, Reisepässe, Führerscheine, Betriebsausweise, Kreditkarten, Verschlüsselungskarten und dergleichen mehr.

### Beschreibung von Ausführungsbeispielen

Weitere Merkmale, Eigenschaften und Vorteile der vorliegenden Erfindung werden im Folgenden anhand von Ausführungsvarianten unter Bezugnahme auf die beigefügten Figuren näher beschrieben.

Die Figuren sind nicht notwendigerweise detailgetreu und maßstabsgetreu und können vergrößert oder verkleinert dargestellt sein, um einen besseren Überblick zu bieten. Daher sind hier offenbarte funktionale Einzelheiten nicht einschränkend zu verstehen, sondern lediglich als anschauliche Grundlage, die dem Fachmann auf diesem Gebiet der Technik Anleitung bietet, um die vorliegende Erfindung auf vielfältige Weise einzusetzen.

Der hier verwendete Ausdruck "und/oder", wenn er in einer Reihe von zwei oder mehreren Elementen benutzt wird, bedeutet, dass jedes der aufgeführten Elemente alleine verwendet werden kann, oder es kann jede Kombination von zwei oder mehr der aufgeführten Elementen verwendet werden. Wird beispielsweise eine Zusammensetzung beschrieben, dass sie die Komponenten A, B und/oder C, enthält, kann die Zusammensetzung A alleine; B alleine; C alleine; A und B in Kombination; A und C in Kombination; B und C in Kombination; oder A, B, und C in Kombination enthalten.
- Fig. 1: zeigt eine schematische Darstellung eines Ausführungsbeispiels eines RFID-Inlays mit einer erfindungsgemäßen Trägerfolie.
- Fig. 2a: zeigt eine schematische Detaildarstellung der Trägerfolie aus Figur 1.
- Fig. 2b: zeigt eine schematische Detaildarstellung einer Ausführungsvariante zu Figur 2a.
- Fig. 3: zeigt schematisch die ersten Schritte einer Ausführungsvariante des erfindungsgemäßen Verfahrens zum Erzeugen einer Durchkontaktierung in einer beidseitig mit Leiterbahnen bedruckten Trägerfolie.
- Fig. 4: zeigt schematisch einen weiteren Schritt dieser Ausführungsvariante des erfindungsgemäßen Verfahrens.
- Fig. 5: zeigt schematisch einen letzten Schritt dieser Ausführungsvariante des erfindungsgemäßen Verfahrens.

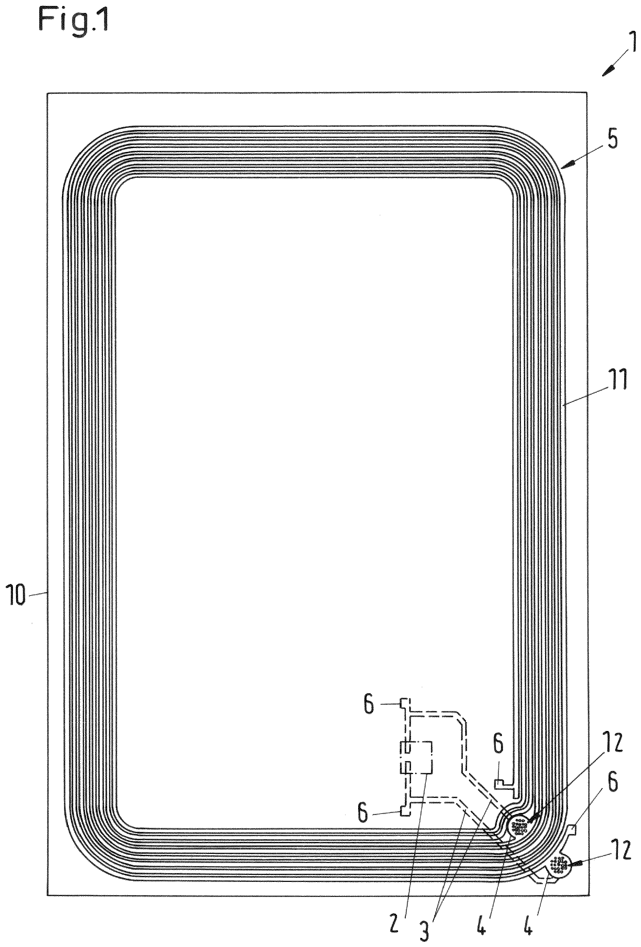

In Figur 1 ist ein RFID-Inlay 1, wie es in Sicherheitsdokumenten (bspw. Reisepässen) Verwendung findet, dargestellt. Das RFID-Inlay 1 umfasst eine erfindungsgemäße Trägerfolie 10, die beidseitig mit Leiterbahnen 11 bedruckt ist. In Figur 1 sind die Leiterbahnen 11 auf der unmittelbar sichtbaren Vorderseite der Trägerfolie 10 in durchgezogenen Linien, die Leiterbahnen 11 auf der Rückseite der Trägerfolie 10 in gestrichelten Linien dargestellt. Das RFID-Inlay 1 umfasst weiterhin den lediglich mit einer Strichpunktlinie angedeuteten RFID-Chip 2, der auf der Rückseite der Trägerfolie 10 angeordnet ist.

Der RFID-Chip 2 des RFID-Inlays 1 ist über Zuleitungen 3 mit Antennenabgriffen 4 einer Antenne 5 verbunden, wobei letztere neben Kommunikationszwecken auch der Energieversorgung dient. Die Zuleitungen 3, die Antennenabgriffe 4 und die Antenne 5 selbst sind durch die auf die Trägerfolie 10 aufgedruckten Leiterbahnen 11 gebildet. Auf der Vorderseite der Trägerfolie 10 ist die Leiterbahn 11 zur Bildung der Antenne 3 spiralförmig ausgestaltet und an den Antennenabgriffen 4 zu lediglich beispielhaft kreisförmig geformten Feldern erweitert. Auf der Rückseite sind die Leiterbahnen 11 als zwei separate Zuleitungen 3 ausgestaltet, die jeweils an ihrem einen Ende (in Figur 1 durch die Antennenabgriffe 4 verdeckte) beispielsweise kreisförmige Felder analog zu den Antennenabgriffen 4 auf der Vorderseite aufweisen. In dem gezeigten Ausführungsbeispiel sind die beiden Zuleitungen 3 an ihren anderen Enden auf einer gemeinsamen Achse aufeinander zulaufend ausgestaltet. Durch diese optionale, aber bevorzugte Ausgestaltung kann die Trägerfolie 10 flexibel mit verschiedenen RFID-Chips 2 bestückt werden, da durch das Layout der Leiterbahnen 11 kein Abstand für die Kontakte des RFID-Chips 2 vorgeschrieben ist, sondern RFID-Chips 2 mit unterschiedlichen Kontaktabständen so auf der Trägerfolie 10 angeordnet werden können, dass jeweils ein Kontakt mit einer Zuleitung 3 verbunden ist.

Zur Verbindung der Leiterbahnen 11 auf der Vorder- und Rückseite der Trägerfolie 10 sind im Bereich der Antennenabgriffe 4 Felder von Durchkontaktierungen 12 vorgesehen, mit denen die Antennenabgriffe 4 elektrisch mit den Zuleitungen 3 und somit die Antenne 5 mit dem RFID-Chip 2 verbunden werden.

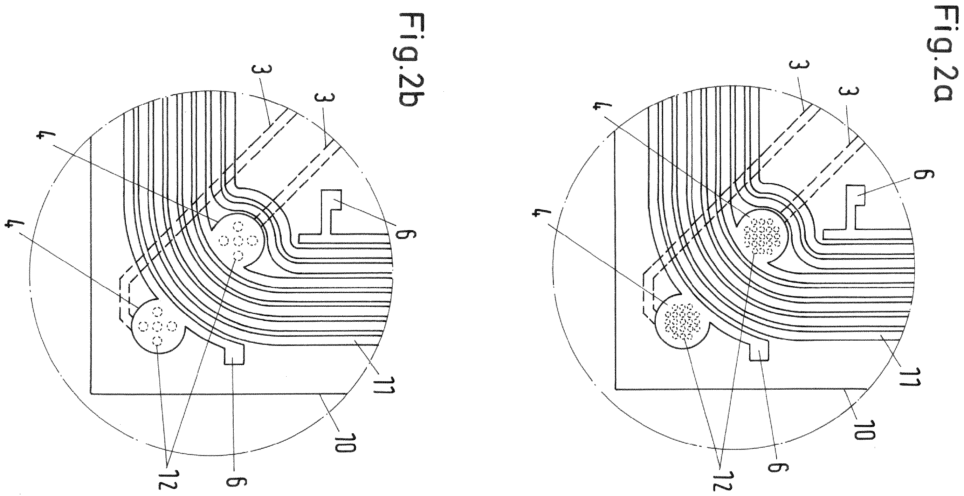

In Figuren 2a und b sind zwei verschiedene Ausführungsvarianten für das Feld von Durchkontaktierungen 12 in schematischen Detailansichten gezeigt, wobei die Variante aus Figur 2a der Darstellung aus Figur 1 entspricht. Die an sich durch die Leiterbahn 11 auf der Vorderseite verdeckten Durchkontaktierungen 12 sind durch Punktlinien angedeutet.

In der Ausführungsvariante gemäß Figur 2a sind im Bereich jedes Antennenabgriffs 4 jeweils 21 Durchkontaktierungen 12 vorgesehen, wobei jede Durchkontaktierung 12 einen Durchmesser von etwa 140 Mikrometer aufweist. In der Ausführungsvariante gemäß Figur 2b sind im Bereich jedes Antennenabgriffs 4 nur jeweils fünf Durchkontaktierungen 12 vorgesehen. Da diese aber jeweils einen Durchmesser von etwa 285 Mikrometer aufweisen, ist der kumulierte elektrische Leitwert eines jeweiligen Feldes von Durchkontaktierungen 12 unter Annahme identischer Materialen und Dicke der Trägerfolie 10 bei beiden Ausführungsvarianten praktisch identisch. Die Erfindung ist nicht auf die gezeigten Zahlen von Durchkontaktierungen 12 beschränkt und kann im Einzelfall mit abweichenden Konstellationen verwirklicht werden.

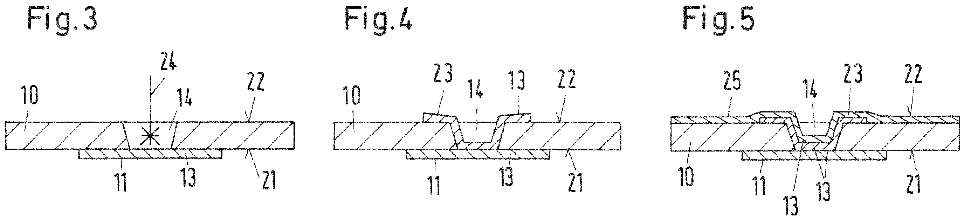

Die Durchkontaktierungen 12 der Trägerfolie 10 des RFID-Chips aus Figuren 1 und 2a, b sind in einem erfindungsgemäßen Verfahren erzeugt worden. Eine Ausführungsvariante des erfindungsgemäßen Verfahrens wird im Folgenden anhand der Figuren 3 bis 5 näher erläutert. Die in den Figuren 3 bis 5 gezeigte Trägerfolie 10 umfasst eine erste Seite 21 und eine zweite Seite 22. Dabei kann es sich jeweils um eine Oberseite oder Unterseite oder Vorderseite oder Rückseite handeln.

In der vorliegenden Variante wird, wie in der Figur 3 schematisch in einer Schnittansicht gezeigt, zunächst die erste Seite 21 der Trägerfolie 10 im Bereich der vorgesehenen Durchkontaktierung mit elektrisch leitendem Material 13, zum Beispiel Silberleitpaste, bedruckt. Dabei kann der Druck beispielsweise den Druck von Leiterbahnen 11 umfassen. Anschließend wird von der zweiten Seite 22 aus ein Durchgangsloch 14 in die Trägerfolie 10 eingebracht. Dies kann mittels eines Lasers 24, vorzugsweise eines CO2-Lasers, aber auch durch Stanzen oder Bohren erfolgen.

In einem anschließenden Schritt, der in der Figur 4 schematisch in einer Schnittansicht gezeigt ist, wird die zweite Seite 22 der Trägerfolie 10 mit elektrisch leitendem Material 13, zum Beispiel Silberleitpaste, bedruckt, wobei das Durchgangsloch 14 - vorzugsweise vollständig - verfüllt wird. Der so erzeugte Fülldruck ist mit der Bezugsziffer 23 gekennzeichnet. Durch den Fülldruck 23 wird sichergestellt, dass die Seitenflächen und Kanten des Durchgangslochs 14 vollständig mit leitfähigem Material überzogen werden.

Danach wird in dem in der Figur 5 schematisch gezeigten Schritt die zweite Seite 22 der Trägerfolie 10 mit elektrisch leitendem Material 13, zum Beispiel Silberleitpaste, erneut bedruckt, wobei das Durchgangsloch 14 und der Fülldruck - vorzugsweise vollständig - überdeckt werden. Der so erzeugte Antennendruck ist mit der Bezugsziffer 25 gekennzeichnet.

Der Fülldruck 23 bewirkt, dass mehr leitfähiges Material in dem Durchgangsloch 14 bzw. in der Durchkontaktierung 12 platziert wird. Dadurch werden eine höhere mechanische Stabilität und ein geringerer elektrischer Widerstand erreicht.

Bei eine Variante, die nicht in den Schutzbereich der Ansprüche fällt, kann auch zuerst das Durchgangsloch 14 in die Trägerfolie 10 eingebracht werden, zum Beispiel mittels eines Lasers 24. Anschließend kann die erste Seite 21 mit leitfähigem Material bedruckt werden, zum Beispiel im Rahmen des Drucks von Leiterbahnen 11. Daran anschließend kann der Fülldruck 23 aufgebracht werden und abschließend der Antennendruck 25.

Es können auch mehrere Fülldruckschritte vorgenommen werden, um die Menge des in dem Durchgangsloch 14 vorhandenen leitfähigen Materials 13 noch weiter zu erhöhen.

Bei dem Bedrucken der ersten Seite 21 kann es sich auch um den Antennendruck und bei dem abschließenden, den Fülldruck überdeckenden Bedrucken der zweiten Seite 22 um den Druck der Leiterbahnen handeln. Diese letzte Ausführungsform fällt nicht unter den Gegenstand des Schutzbegehrens.

### Bezugszeichenliste-

- 1: RFID-Inlay
- 2: RFID-Chip
- 3: Zuleitung
- 4: Antennenabgriff
- 5: Antenne
- 6: Kontaktstellen
- 10: Trägerfolie
- 11: Leiterbahn
- 12: Durchkontaktierung
- 13: elektrisch leitendes Material
- 14: Durchgangsloch
- 21: erste Seite
- 22: zweite Seite
- 23: Fülldruckschicht
- 24: Laser
- 25: Antennendruckschicht

## Patentansprüche

1. Verfahren zum Erzeugen einer Durchkontaktierung (12) in einer beidseitig mit Leiterbahnen (11) bedruckten Trägerfolie (10) mit einer ersten und einer zweiten Seite (21, 22), wobei das Verfahren folgende Schritte umfasst:
- Bedrucken der ersten Seite (21) der Trägerfolie (10) mit elektrisch leitendem Material (13), wobei der Bereich der vorgesehenen Durchkontaktierung (12) überdeckt wird,
- nach dem Bedrucken der ersten Seite (21) erfolgt ein Einbringen eines Durchgangsloches (14) in die Trägerfolie (10), wobei das bereits aufgebrachte elektrisch leitende Material (13) erhalten bleibt,
- Bedrucken der zweiten Seite (22) der Trägerfolie (10) mit elektrisch leitendem Material (13), wobei das Durchgangsloch (14) mit einem Fülldruck (23) verfüllt wird, und
- mindestens ein weiteres Bedrucken der zweiten Seite (22) der Trägerfolie (10) mit elektrisch leitendem Material (13), wobei das Durchgangsloch (14) und das bereits aufgedruckte elektrisch leitende Material des Fülldrucks (23) wenigstens teilweise überdeckt werden, und wobei beim weiteren Bedrucken der zweiten Seite (22) der Trägerfolie (10) zugleich ein Antennendruck (25) aus dem elektrisch leitenden Material (13) aufgebracht wird.

2. Verfahren nach Anspruch 1, **dadurch gekennzeichnet, dass** das Bedrucken mittels Siebdruck oder mittels eines Jet-Druckverfahrens erfolgt.

3. Verfahren nach einem der vorhergehenden Ansprüche, **dadurch gekennzeichnet, dass** der Durchmesser des Durchgangslochs (14) 50 Mikrometer bis 5000 Mikrometer, vorzugsweise 50 Mikrometer bis 200 Mikrometer oder 100 Mikrometer bis 500 Mikrometer, und/oder die Dicke der Trägerfolie (10) 20 Mikrometer bis 250 Mikrometer, vorzugsweise 75 Mikrometer bis 125 Mikrometer, beträgt.

4. Verfahren nach einem der vorhergehenden Ansprüche, **dadurch gekennzeichnet, dass** das Einbringen des Durchgangslochs (14) durch Stanzen, Bohren oder Lasern (24), vorzugsweise CO2-Lasern, erfolgt.

5. Verfahren nach einem der vorhergehenden Ansprüche, **dadurch gekennzeichnet, dass** das elektrisch leitende Material (13) Silberleitpaste umfasst.

6. Verfahren nach einem der vorhergehenden Ansprüche, **dadurch gekennzeichnet, dass** die Trägerfolie (10) Polycarbonat umfasst.

7. Trägerfolie (10), welche beidseitig mit Leiterbahnen (11) bedruckt ist und wenigstens eine gemäß einem der vorhergehenden Ansprüche hergestellte Durchkontaktierung (12) aufweist.

8. Trägerfolie (10) nach Anspruch 7, **dadurch gekennzeichnet, dass** jeweils eine Leiterbahn (11) auf unterschiedlichen Seiten der Trägerfolie (10) durch ein Feld von wenigstens zwei Durchkontaktierungen (12) elektrisch miteinander verbunden sind.

9. Trägerfolie nach Anspruch 7 oder 8, **dadurch gekennzeichnet, dass** zwei durch wenigstens eine Durchkontaktierung (12) verbundene Leiterbahnen (11) Kontaktstellen (6) zur Überprüfung der Durchkontaktierung (12) umfassen.

10. RFID-Inlay (1) mit einer Trägerfolie (10) nach einem der Ansprüche 7 bis 9 und einem mit den Leiterbahnen (11) verbundenen RFID-Chip (2).

11. Wert- oder Sicherheitsdokument mit einem RFID-Inlay gemäß dem vorhergehenden Anspruch.

## Claims

1. A method for producing a through-contact plating (12) in a carrier film (10) printed on both sides with conductor tracks (11) and having a first and a second side (21, 22), wherein the method comprises the following steps:
- printing of the first side (21) of the carrier film (10) with electrically conductive material (13), whereby the area of the prospective through-contact plating (12) is covered,
- after printing the first side (21), a through hole (14) is made in the carrier film (10), wherein the already applied electrically conductive material (13) is retained,
- printing of the second side (22) of the carrier film (10) with electrically conductive material (13), wherein the through hole (14) being filled with a filling print (23), and
- at least one further printing of the second side (22) of the carrier film (10) with electrically conductive material (13), wherein the through hole (14) and the already printed electrically conductive material of the filling print (23) are at least partially covered, and wherein during the further printing of the second side (22) of the carrier film (10) an antenna print (25) of the electrically conductive material (13) is applied at the same time.

2. The method according to claim 1, **characterized in that** the printing is carried out by means of screen printing or by means of a jet printing process.

3. The method according to one of the preceding claims, **characterized in that** the diameter of the through hole (14) is 50 micrometers to 5000 micrometers, preferably 50 micrometers to 200 micrometers or 100 micrometers to 500 micrometers, and/or the thickness of the carrier film (10) is 20 micrometers to 250 micrometers, preferably 75 micrometers to 125 micrometers.

4. The method according to one of the preceding claims, **characterized in that** the through hole (14) is introduced by punching, drilling or lasering (24), preferably CO2 lasering.

5. The method according to one of the preceding claims, **characterized in that** the electrically conductive material (13) comprises silver conductive paste.

6. The method according to one of the preceding claims, **characterized in that** the carrier film (10) comprises polycarbonate.

7. A carrier film (10), which is printed on both sides with conductor tracks (11) and has at least one through-contact plating (12) produced in accordance with one of the preceding claims.

8. The carrier film (10) according to claim 7, **characterized in that** in each case one conductor track (11) on different sides of the carrier film (10) is electrically connected to one another by an array of at least two through-contact platings (12).

9. The carrier film according to claim 7 or 8, **characterized in that** two conductor tracks (11) connected by at least one through-contact plating (12) comprise contact points (6) for checking the through-contact plating (12).

10. A RFID inlay (1) with a carrier film (10) according to one of claims 7 to 9 and an RFID chip (2) connected to the conductor tracks (11).

11. A value or security document with an RFID inlay according to the preceding claim.

## Revendications

1. Procédé de génération d'un contact traversant (12) dans un film de support (10) imprimé des deux côtés avec des pistes conductrices (11) avec un premier et un second côté (21, 22), dans lequel le procédé comprend les étapes suivantes:
- l'impression du premier côté (21) du film de support (10) avec un matériau électroconducteur (13), dans lequel la zone du contact traversant (12) prévu est recouverte,
- après l'impression du premier côté (21), un trou traversant (14) est réalisé dans le film de support (10), dans lequel le matériau électroconducteur (13) déjà appliqué reste maintenu,
- l'impression du second côté (22) du film de support (10) avec un matériau électroconducteur (13), dans lequel le trou traversant (14) s'effondre avec une pression de remplissage (23), et
- au moins une autre impression du second côté (22) du film de support (10) avec un matériau électroconducteur (13), dans lequel le trou traversant (14) et le matériau électroconducteur déjà imprimé de la pression de remplissage (23) sont recouverts au moins partiellement, et dans lequel lors de l'autre impression du second côté (22) du film de support (10), une pression d'antenne (25) est appliquée en même temps à partir du matériau électroconducteur (13).

2. Procédé selon la revendication 1, **caractérisé en ce que** l'impression est effectuée par sérigraphie ou au moyen d'un procédé d'impression par jet.

3. Procédé selon l'une quelconque des revendications précédentes, **caractérisé en ce que** le diamètre du trou traversant (14) est compris entre 50 micromètres et 5 000 micromètres, de préférence 50 micromètres et 200 micromètres ou 100 micromètres et 500 micromètres, et/ou l'épaisseur du film de support (10) est comprise entre 20 micromètres et 250 micromètres, de préférence 75 micromètres et 125 micromètres.

4. Procédé selon l'une quelconque des revendications précédentes, **caractérisé en ce que** le trou traversant (14) est réalisé par estampage, perçage ou émission de faisceau laser (24), de préférence laser au CO2.

5. Procédé selon l'une quelconque des revendications précédentes, **caractérisé en ce que** le matériau électroconducteur (13) comprend une pâte d'argent conductrice.

6. Procédé selon l'une quelconque des revendications précédentes, **caractérisé en ce que** le film de support (10) comprend du polycarbonate.

7. Film de support (10) qui est imprimé des deux côtés avec des pistes conductrices (11) et présente au moins un contact traversant (12) fabriqué selon l'une quelconque des revendications précédentes.

8. Film de support (10) selon la revendication 7, **caractérisé en ce que** respectivement une piste conductrice (11) est reliée électriquement sur différents côtés du film de support (10) par un champ d'au moins deux contacts traversants (12).

9. Film de support selon la revendication 7 ou 8, **caractérisé en ce que** deux pistes conductrices (11) reliées par au moins un contact traversant (12) comprennent des points de contact (6) pour la vérification du contact traversant (12).

10. Marqueur RFID (1) avec un film de support (10) selon l'une quelconque des revendications 7 à 9 et une puce RFID (2) reliée aux pistes conductrices (11).

11. Document de valeur ou de sécurité avec un marqueur RFID selon la revendication précédente.
